# EUROPEAN PATENT APPLICATION

(11) **EP 2 375 456 A1**
(43) Date of publication of application: **12.10.2011**
(21) Application number: 11171887.0
(22) Date of filing: 06.03.2009
(51) Int. Cl.: H01L 31/052, H01L 31/18

(54) **Low cost solar cell**

(62) Divisional of application: 09154530.1
(71) Applicant: Suinno Solar Oy, 00131 Helsinki (FI)
(72) Inventor: Väänänen, Mikko, 00131 Helsinki (FI)
(74) Representative: Väänänen, Mikko Kalervo

(57) **Abstract**

The invention relates to a new low cost solar cell. A solar module (10) in accordance with the invention is characterised in that, at least one solar cell (100, 101, 102) is arranged into a housing (500), at least one reflective cavity (200) is arranged into said housing (500), at least one focusing element (300) is arranged to focus incident sunlight into at least one said reflective cavity (200), the said at least one reflective cavity is arranged to house the said at least one solar cell (100, 101, 102), at least one said focusing element (300) is realised integrally in connection with the housing (500). The best mode of the invention is considered to be a tandem solar cell with multiple spectral responses housed in a porous ceramic housing (500) comprising a plastic lens (300). The housing (500) is covered in mirror foil (200) from within. In some embodiments the tandem solar cell is underneath the focus of the focusing element (300), and there is also a vacuum within the housing (500). The solar module (10) can be used as a building material, such as a brick in some embodiments.

## Description

### BACKGROUND

The performance of photovoltaic solar cells has been under constant development for decades. Over the years several attempts have been launched towards improving their efficiency and power generated. These include the patent applications of the inventor FI 20070264, FI20070743 and FI2007801 which are incorporated herein as reference into this application.

US 6689949 also describes an interesting attempt to establish a solar power plant in the few kW - 50 kW range. External parabolic optical concentrators are used to concentrate solar light into a reflective cavity made from "Spectralon", a space grade reflector material. The reflective cavity contains solar cells at different wavelengths. US 2008/0251112 Al also presents a similar solution. Both documents are cited here as reference.

The prior art is burdened by important disadvantages. The power plant of US 6689949 is so large that electricity transfer costs increase, because it needs to be away from the point of use of electricity. In addition, the power plant is very expensive, in terms of average cost per watt produced as well as capital costs, because it needs a large upfront investment. The situation today in renewable energy is that photovoltaic electricity production is the preferred mode of energy production, but it is simply too expensive per unit watt for the average person or industry.

### SUMMARY

The invention under study is directed towards a low cost solar cell.

One goal of the invention is to bring power plant grade photovoltaic technology available to the point of use of electricity.

A further goal of the invention is to reduce the cost per unit Watt of electricity by reducing the initial investment required to the solar panels.

In one aspect of the invention a solar panel is made from a number of small solar modules. These modules could be the area of a few cm² and have a thickness of a few cm or less. The solar module comprises a housing for a solar cell. There is a focusing element on the incident sunlight side of the housing. This focuses sunlight into a small area. The solar cell is below this focusing area and gets a maximum of the incident sunlight. The solar cell typically has a small area in comparison to the area of the focusing element or the housing element. The housing also works as a reflecting cavity or an integrating sphere, and its inner walls are covered with reflective foil, or diffusively reflective material, or other reflective material.

As said, solar cells are expensive. The cost of a solar cell or photodiode scales in a very strong relation to its area. The same is true for the energy consumed in making the semiconductor material that results in a solar cell. On the other hand many semiconductors do benefit from an increase in irradiance (i.e. increased flux), as their efficiency is enhanced. This is because the more photons there are, the more excited electrons into the conduction band result. On the other hand, the focusing element and the reflective cavity that causes the focusing and the entrapment of photons can be produced in a multitude of ways. In one embodiment of the invention the housing is a transparent plastic housing and the focusing element is a cheap plastic lens, and the internal sides of the cavity, i.e. the housing, have been covered with cheap mirror foil to turn it into a reflective cavity.

In one embodiment of the invention the housing, focusing element and mirror foil are arranged to be chosen so that their cost and installation cost are at least offset by the value of the added electricity produced by the entrapped photons and the focused photons.

A solar module in accordance with the invention is characterised in that,
- at least one solar cell is arranged into a housing,
- at least one reflective cavity is arranged into said housing,
- at least one focusing element is arranged to focus incident sunlight into at least one said reflective cavity,
- the said at least one reflective cavity is arranged to house the said at least one solar cell,
- at least one said focusing element is realised integrally in connection with the housing.

A method to produce solar electricity in accordance with the invention is characterised in that,
- a focusing element focuses incident sunlight into a reflective cavity,
- reflective cavity houses at least one solar cell,
- the focusing and reflection of photons are conducted inside the same housing.

In addition and with reference to the aforementioned advantage accruing embodiments, the best mode of the invention is considered to be a tandem solar cell with multiple spectral responses housed in a porous ceramic housing comprising a plastic lens. The housing is covered in mirror foil from within. In some embodiments the tandem solar cell is underneath the focus of the focusing element, and there is also a vacuum within the housing.

### BRIEF DESCRIPTION OF THE DRAWINGS

In the following the invention will be described in greater detail with reference to exemplary embodiments in accordance with the accompanying drawings, in which

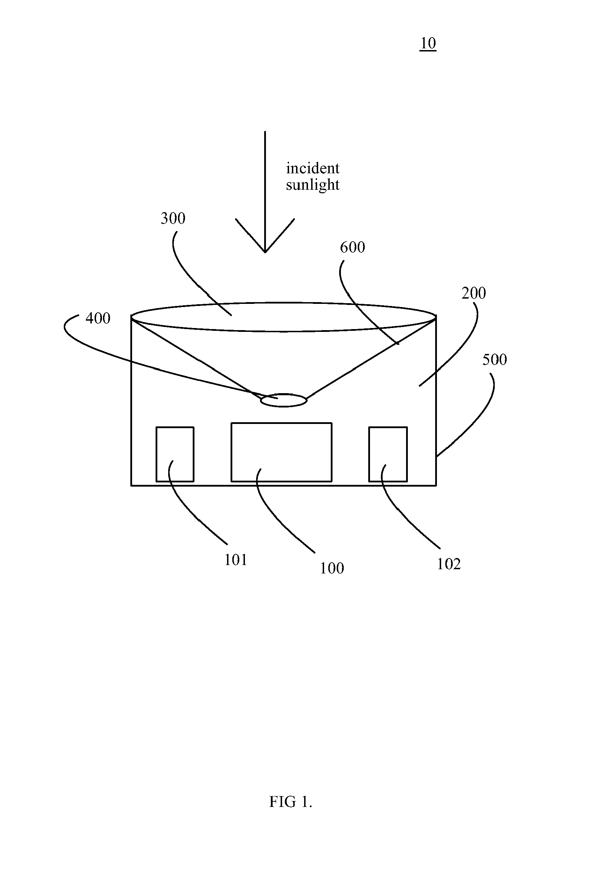

Figure 1 demonstrates an embodiment of an inventive solar module 10 as a block diagram.

Some of the embodiments are described in the dependent claims.

### DETAILED DESCRIPTION OF EMBODIMENTS

Figure 1 shows an embodiment of the inventive solar module 10. In some embodiments the solar module (10) housing is made from plastic, which is a relatively inexpensive material. In some embodiments the solar module 10 housing is made from glass or a glass/plastic mixture. The focusing element 300 is made from plastic, glass or glass/plastic mixture in some embodiments, and may be an integral part of the housing 500 of the solar module 10. In some embodiments the housing 500 and the focusing element are made from a single glass and/or plastic piece, for example by moulding.

The focusing element 300 is a lens in some embodiments of the invention, but it may also be a parabolic mirror or other focusing device in accordance with the invention. The focusing element is integrally connected to the housing 500 in most embodiments of the invention. One or more of the walls of the housing 500 is/are realised as a focusing element 300, or the walls are arranged to contain a focusing element 300 at least in a portion of their area. In some embodiments a photon conductor, such as at least one an optical fibre or periscope, can be used to integrally connect the focusing element 300 into the housing 500.

In some embodiments the housing and the focusing element are made from different materials. For example the housing 500 could be made from a porous ceramic, which is the cheapest generic material (source: Cambridge University Engineering Department, UK), the focusing element 300 from plastic, glass and/or glass/plastic mixture and the reflective cavity could be realised with mirror foil from any metal or alloy or any other material. In some embodiments the reflective cavity 200 is realised inside the housing 500 by covering the inner walls with reflective foil, which may be based on any metal or alloy or any other material.

In some embodiments of the invention there is a further focusing, diverging, and/or diffracting element 400 approximately at the mouth of the reflective cavity inside the housing. This element 400 can be used to optimise the initial internal photon distribution inside the reflective cavity. Also the entrapment wall 600 of the reflective cavity 200 is also important. The photons are reflected from it and other walls of the reflective cavity 200 and cannot really escape unless they manage to get reflected back to the element 400 which has a very small area in most embodiments. Therefore the reflective cavity 200 traps photons and forces them to interact several times with the solar cells 100, 101, 102, thereby increasing the probability of their conversion into current in at least one solar cell.

The focusing element 300 is arranged to focus the incident sunlight into a reflective cavity 200. There may be a further focusing and/or diffracting/diffusing element 400 at the aperture of the reflective cavity. In some embodiments the reflective cavity (200) is realised inside the solar module (10) by covering the internal walls with mirror foil. In some embodiments the reflective cavity is arranged as an integrating sphere. In these embodiments the walls are reflective in a diffusive way, which often implies that the walls are white. The solar module and the reflective cavity may be of any shape in accordance with the invention. In some embodiments of the invention, there is a vacuum or low density gas inside at least one reflective cavity (200) and/or housing (500).

In some embodiments of the invention the housing 500, the reflective cavity 200, the focusing element 300, diffracting/diffusing element 400, or any other part of the solar module 10 may be based on any metal or alloy, ceramic, porous ceramic, glass, composite, plastic, polymer, rubber, foam, wood and/or wood product.

At least one solar cell 100, 101, 102 may be a Si (Silicon), polycrystalline silicon, thin-film silicon, amorphous silicon, Ge (Germanium), GaAs (Gallium Arsenide), GaAlAs (Gallium Aluminum Arsenide), GaAlAs/GaAs, GaP (Gallium Phosphide), InGaAs (Indium Gallium Arsenic), InP (Indium phosphide), InGaAs/InP, GaAsP (Gallium Arsenic Phosphide) GaAsP/GaP, CdS (Cadmium Sulphide), CIS (Copper Indium Diselenide), CdTe (Cadmium Telluride), InGaP (Indium Gallium Phosphide), AlGaInP (Aluminium Gallium Indium Phosphide), InSb (Indium Antimonide), CIGS (Copper Indium/Gallium diselenide) and/or InGaN (Indium Gallium Nitride) solar cell in accordance with the invention. Likewise at least one solar cell 100, 101, 102 in accordance with the invention may feature any element or alloy combination, or any material capable of photoelectric effect described in the publications EP 1724 841 A1, Josuke Nakata, "Multilayer Solar Cell", US 6320117, James P. Campbell et al., "Transparent solar cell and method of fabrication", Solar Electricity, Thomas Markvart, 2nd Edition, ISBN 0-471-98852-9 and "An unexpected discovery could yield a full spectrum solar cell, Paul Preuss, Research News, Lawrence Berkeley National Laboratory in some embodiments, which publications are all incorporated into this application by reference in accordance with the invention. At least one solar cell 100, 101 and/or 102 may also be a intraband-gap semiconductor, such as a quantum cascade semiconductor. In some embodiments this could be realised for example with a QCL laser driven in reverse (i.e. as a photoreceiver).

In most embodiments at least one solar cell 100, 101, 102 is arranged to be placed to the focus of the focusing element 300. In some embodiments at least one solar cell 100, 101, 102 may be provided with a filter, which will typically have a band pass at the band where that solar cell is most efficient. This is because it is sensible to provide photons from that part of the spectrum to the solar cell where it has the best quantum efficiency in accordance with the invention. One example of such a filter is a Rugate filter. Alternatively the element 400 can be arranged to distribute photons from certain parts of the spectrum to a specific solar cell 100, 101, 102 that works best at that band. In some embodiments this could be achieved by arranging the element 400 as a diffracting prism and placing the various solar cells at locations of diffraction maximum that corresponds to their best band in terms of efficiency. In some embodiments of the invention both filters and photon distribution method are used together.

In one embodiment of the invention several solar cells 100, 101, 102 of different spectral responses are arranged into the reflective cavity 200, and/or at least one solar cell 100, 101, 102 is a tandem solar cell. The use of these sophisticated photovoltaic solutions is now economically feasible because in the reflective cavity they will be exposed to higher irradiances, and a higher level of use will be achieved and more photocurrent will be extracted.

In most embodiments of the invention, the photocurrent collected by any of the solar cells 100, 101, 102 is arranged to be collected by electrical conductors arranged to lead out of the solar module 10. For example metal wires or other conductors connected to any of the solar cells 100, 101, 102 may be taken out of the reflective cavity 200 to power a network or drive a load or charge a battery outside and/or far away from the solar module in accordance with the invention.

In some embodiments at least one solar module 10 is aggregated to form a solar panel comprising one or more solar modules. The solar modules of the invention can be made very tiny. They can be used to power a wristwatch for example. However, also huge solar panels could be constructed from aggregations of thousands or millions of solar modules that could be used in a solar power plant. The solar module itself can also be made very large, for example the size of a hall or house. The solar module 10 itself or a solar panel thereof can thus be realised in any size, shape or configuration.

The additional photocurrent produced from focused and entrapped photons by the solar cells 100, 101, 102 is arranged to offset the cost of the reflective cavity 200 and/or focusing element 300, and/or the module 10 or its housing 500 in most embodiments of the invention. For example, let's say the solar cell 100 has an effective area of 1 cm², and the module area is higher with the focusing element having an area of 10 cm². The focusing element 300 can be of any shape, square or circular lens for example in some embodiments. Now the solar cell 100 is exposed to roughly 10 times more flux, assuming ideal conditions, i.e. 10 Suns. Suppose it produces 3 times more power under these conditions in comparison to what it would have been able to produce under 1 Sun. Now, as a plastic casing costs next to nothing to make, it will be quite probable that the whole solar module system, including the reflective cavity, housing and the focusing element will cost less than the cost of two solar cells. If we assume the endurance of the solar cell to be not affected by the optical concentration, and the price of the solar module to be equal to the price of the solar cell, there is a cost reduction of 1/3=33% to be made in using the solar cell inside the solar module. Thus, in the inventive solar panel, the cost of the solar module will be preferably more than offset by the relative gain in photocurrent from the focused and entrapped photons. In other words, the relative increase in photocurrent due to entrapment and focusing is arranged higher than the relative cost of the housing 500, focusing element 300 and the reflective cavity 200 to the solar cell cost (100, 101, 102). The integral contact of the focusing element with the housing 500 and/or the reflective cavity 200 allows this cost-power optimisation to be conducted per each solar module and/or per each solar panel in accordance with the invention.

It has been discussed before that the focusing element, reflective cavity and solar module would be made from cheap plastic, glass, or a mixture of the two. It has also been discussed that in some embodiments of the invention the housing 500, the reflective cavity 200, the focusing element 300, focusing/diffracting/diffusing element 400, or any other part of the solar module 10 may be based on any metal or alloy, ceramic, porous ceramic, glass, plastic, composite, polymer, rubber, foam, wood and/or wood product. It is of course possible that any other material satisfying the relative cost-gain test be used in accordance with the invention.

The solar module 10 of the invention can be realised in any shape, size, use or camouflage. For example a low cost solar power plant could be built and used based on solar panels using said solar modules. Individual solar panels can be built based on the solar module of the invention and can be used at any locations, for example at a points of use of electricity, such as homes, offices and the like.

Because all of the optics and the at least one solar cell are inside the same housing a very preferable embodiment of the invention is the aggregate solar panel composed of many solar modules as elements. Because the solar panel should not be too thick, the focal length of the focusing element 300 should preferably be quite short. This also imposes limitations on the area of the focusing element. In one embodiment the solar panel is about 1 cm in thickness, and the focusing element has a focal length of about 1 cm with the solar cells residing at the back wall of the reflective cavity (200) and the housing (500). Based on these dimensions, an area of a few square centimetres is for example possible for the focusing element (300). Therefore in this embodiment, a solar panel a square meter in area would be composed of a larger number of small solar modules (10), each having an area of a few square cm. In some embodiments the solar modules 10 are laid out on a flat plane to realise a flat solar panel, but other shapes are also possible. A solar panel composed of solar modules 10 could be assembled to fit any shape, such as a spherical or round object in some embodiments. Likewise the housing 500, focusing element 300 and the reflective cavity 300 and any of the solar cells 100, 101 102 can have different shapes in some embodiments of the invention. The integral contact of the housing 500, focusing element 300 and/or the reflective cavity 300 allows all the benefits of optical concentration based cost-power optimisation right at the point of use of electricity at any shape, size or form in accordance with the invention.

In some embodiments of the invention a solar panel comprising a large number of solar modules is manufactured in sheets. A sheet of many small cavities is covered with reflective foil or some other reflective material, for example by spraying and/or melting in some embodiments. Then the solar cells are wired with conductors to each cavity in accordance with the invention. Then a sheet of focusing elements is attached on top of the sheet of cavities housing solar cells, the two sheets together forming a solar panel. The solar cells are preferably arranged in the focus of each focusing element. This way a whole solar panel featuring a large number of solar modules of the invention could be manufactured in accordance with the invention in some embodiments.

In some embodiments of the invention the solar module 10 or a solar panel thereof could be used as a building material, such as a brick, building element or the like. For example solar module 10 could be realised as a brick with a lens or similar focusing element on the Sun incident side. In these embodiments a vacuum inside the brick would be very preferable to thermally insulate the building from the surroundings in some embodiments of the invention. The vacuum and the containment inside the brick will also typically prolong the lifespan of the solar cell, as it is not exposed to the environment. The Voyager satellite has been running on the same solar panels perfectly for 32 years, when the solar panels have been kept in the relative vacuum of the outer solar system and the heliosphere.

The solar cells inside the bricks are connected by electrical contacts to each other and/or a load and the whole wall made of such bricks, or a part of it, could be made to run loads inside the house. In some embodiments of the invention the bricks are connected in series or parallel or both. In some embodiments the bricks have one or more electrical contacts on their faces. The current is collected by wires leading through the electrical contacts on the inside external face of the brick, i.e. the opposite side to the incident sunlight side (=external outside). It is also possible in some embodiments to have brick-to-brick electrical contacts on the top and/or bottom external faces of the brick. It is important to avoid the disconnection of the electrical connection by mortar or plaster, when the wall gets assembled, and in some embodiments the electrical contacts are elevated, lowered, covered or arranged to be interleaved so that the mortar or plaster will not disconnect the electrical contact when the wall is being built. Other support structures can also be used in accordance with the invention, for example a metal rod running through the brick and doubly used as an electrical connector or a host to other electrical connectors.

In embodiments of the invention where the solar module is used as a building material the combined gain in savings from building materials, reduced heating or airconditioning due to vacuum insulation and the increased photocurrent due to focused and entrapped photons can be used to offset the cost of the solar module 10 itself. Therefore the solar power generating building material of the invention will make photovoltaic power more financially accessible to households, consumers and businesses.

The invention has been explained above with reference to the aforementioned embodiments and several commercial and industrial advantages have been demonstrated. The methods and arrangements of the invention allow a solar panel that has an extremely low cost per unit Watt produced.

The invention has been explained above with reference to the aforementioned embodiments. However, it is clear that the invention is not only restricted to these embodiments, but comprises all possible embodiments within the spirit and scope of the inventive thought and the following patent claims.

### REFERENCES

FI20070264 An active solar cell and method of manufacture
FI20070743 Thermodynamically shielded solar cell
FI20070801 Method and means for designing a solar cell
EP 1724 841 A1, Josuke Nakata, "Multilayer Solar Cell"
US 6320117, James P. Campbell et al., "Transparent solar cell and method of fabrication"
US 6689949, Ugur Ortabasi, Concentrating photovoltaic cavity converters for extreme solar-to-electric conversion efficiencies.
US 2008/0251112A1, David g. Jenkins, Concentrating photovoltaic kaleidoscope and method.
Solar Electricity, Thomas Markvart, 2nd Edition, ISBN 0-471-98852-9
"An unexpected discovery could yield a full spectrum solar cell, Paul Preuss, Research News, Lawrence Berkeley National Laboratory.

## Claims

1. A solar module (10) **characterised in that,**
- at least one solar cell (100, 101, 102) is arranged inside a housing (500),
- at least one reflective cavity (200) is arranged inside said housing (500),
- at least one focusing element (300) is arranged to focus incident sunlight into at least one said reflective cavity (200),
- the said at least one reflective cavity is arranged to house the said at least one solar cell (100, 101, 102),
- at least one said focusing element (300) is realised integrally in connection with the housing (500).

2. A solar module as claimed in claim 1 **characterised in that,** at least one focusing element (300) is arranged to at least one side of the housing (500).

3. A solar module as claimed in claim 1 **characterised in that,** at least one reflective cavity (200) is arranged within the housing (500) by covering the internal walls of the housing with reflective material.

4. A solar module as claimed in claim 1 **characterised in that,** the additional photocurrent produced from focused and entrapped photons by the solar cell is arranged to compensate for or offset the cost of the reflective cavity (200), housing (500) and/or focusing element (300).

5. A solar module as claimed in claim 1 **characterised in that**, the solar module (10) housing (500) is made from porous ceramic, the focusing element (300) is made from plastic, and/or the reflective cavity (200) is realised by covering the inside walls of the housing (500) with mirror foil.

6. A solar module as claimed in claim 1, **characterised in that**, the housing (500) and the focusing element (300) are made from any material or plastic into one integral element.

7. A solar module as claimed in claim 1, **characterised in that,** the housing (500), the reflective cavity (200), the focusing element (300), diffracting/diffusing element (400), or any other part of the solar module (10) are based on any metal or alloy, ceramic, porous ceramic, glass, plastic, composite, polymer, rubber, foam, wood and/or wood product.

8. A solar module as claimed in claim 1, **characterised in that,** there is a vacuum or low density gas inside at least one reflective cavity (200).

9. A solar module as claimed in claim 1, **characterised in that,** at least one solar module (10) is aggregated to form a solar panel comprising one or more solar modules (10).

10. A solar module as claimed in claim 1, **characterised in that,** several solar cells (100, 101, 102) of different spectral responses are arranged into the reflective cavity (200) , and/or at least one solar cell (100, 101, 102) is a tandem solar cell.

11. A solar module as claimed in claim 1, **characterised in that,** the photocurrent collected by the solar cells (100, 101, 102) is collected by at least one electrical conductor arranged to lead out of the solar module (10).

12. A solar module as claimed in claim 1, **characterised in that,** the solar module (10) is arranged to be used as building material.

13. A method to produce solar electricity **characterised in that**,
- at least one focusing element (300) focuses incident sunlight into a reflective cavity (200),
- at least one reflective cavity houses at least one solar cell (100, 101, 102),
- the focusing and reflection of photons by the at least one focusing element (300) and the at least one reflective cavity (200) are conducted in the same housing (500) and/or on the walls of the same housing (500).

14. A method to produce electricity with the solar module (10) of claim 1.
